# EUROPÄISCHE PATENTANMELDUNG

(11) **EP 2 626 870 A1**
(43) Veröffentlichungstag der Anmeldung: **14.08.2013**
(21) Anmeldenummer: 13151590.0
(22) Anmeldetag: 17.01.2013
(51) Int. Cl.: H01F 27/02, H01F 27/06, H01F 38/28, H01F 38/30

(54) **Kombinationswandleranordnung und Schaltgerät**

(30) Priorität: 10.02.2012 DE 102012201992
(71) Anmelder: Siemens Aktiengesellschaft, 80333 München (DE)
(72) Erfinder: Gross, Markus, 92284 Poppenricht (DE); Kiendl, Thomas, 92533 Wernberg-Köblitz (DE)

(57) **Zusammenfassung**

Die Erfindung betrifft eine Kombinationswandleranordnung (8) sowie ein Schaltgerät (1) mit einer solchen Kombinationswandleranordnung (8). Als Kombinationswandler (9) wird die Kombination eines Stromwandlers (12) mit einem Kern aus ferromagnetischen Werkstoff und einer Rogowskispule (11) bezeichnet, wobei der Stromwandler (12) zur Energieversorgung der elektronischen Auslöseeinheit (6) des Schaltgerätes (1) dient und die Rogowskispule (11) zur Strommessung. Um den in dem Schaltgerät (1) für den Einbau von Kombinationswandlern (9) zur Verfügung stehenden Einbauraum optimal auszunutzen, wird vorgeschlagen, mehrere Kombinationswandler (9) in einem gemeinsamen Gehäuse (10) anzuordnen und dadurch ein mehrpoliges Kombinationswandlermodul bereitzustellen.

## Beschreibung

Die Erfindung betrifft eine Kombinationswandleranordnung sowie ein Schaltgerät mit einer solchen Kombinationswandleranordnung.

Aus dem Stand der Technik sind Schaltgeräte mit elektronischer Auslöseeinheit bekannt, die pro Phase über einen Stromwandler mit Eisenkern sowie über eine Rogowskispule verfügen. Der Stromwandler mit Eisenkern dient der Energieversorgung der elektronischen Auslöseeinheit. Die Ausgangsspannung der Rogowskispule ist proportional zur zeitlichen Ableitung des Stroms im Leiter, den die Rogowskispule umfasst. Aus dieser Ausgangsspannung wird in der elektronischen Auslöseeinheit der zeitliche Verlauf des Stromes im Leiter erfasst. Die Kombination aus Stromwandler mit Eisenkern sowie Rogowskispule wird nachfolgend als Kombinationswandler bezeichnet. Kombinationswandler werden in der Regel in Niederspannungs-Leistungsschaltern mit Nennströmen im Bereich von etwa 25 A bis 6300 A eingesetzt und ermöglichen die Messung von Strömen im Bereich von wenigen Ampere bis größer 100 kA. Für jede Phase des Leistungsschalters wird dabei ein eigener Kombinationswandler mit Gehäuse verwendet. Durch die als Trennelemente dienenden Gehäuse werden die benötigten Luft- und Kriechstrecken zum einen zwischen den einzelnen Phasen und zum anderen zwischen den Phasen und der elektronischen Auslöseeinheit eingehalten. Darüber hinaus ermöglicht diese Bauart eine flexible Bestückung der Leistungsschalter mit Kombinationswandlern, je nachdem, ob es sich um eine zwei-, drei- oder vierpolige Ausführung handelt.

Eine Aufgabe der vorliegenden Erfindung ist es, den in einem Schaltgerät für den Einbau von Kombinationswandlern zur Verfügung stehenden Einbauraum optimal auszunutzen. Diese Aufgabe wird durch eine Kombinationswandleranordnung nach Anspruch 1 bzw. durch ein Schaltgerät nach Anspruch 8 gelöst. Vorteilhafte Ausführungen der Erfindung sind in den Unteransprüchen angegeben.

Eine Kernidee der Erfindung ist es, mehrere Kombinationswandler in einem gemeinsamen Gehäuse anzuordnen und dadurch ein mehrpoliges Kombinationswandlermodul bereitzustellen. Die Erfindung ist besonders vorteilhaft im Bereich der Niederspannung einsetzbar. Insbesondere können mit der erfindungsgemäßen Kombinationswandleranordnung eigenversorgte Niederspannungsleistungsschalter mit elektronischer Auslöseeinheit realisiert werden, in denen durch die Verwendung von Rogowskispulen und die dadurch erzielbare hohe Strommessgenauigkeit nicht nur sehr genaue Schutzfunktionen, wie etwa Überlast-und Kurzschlussschutz, sondern auch sehr genaue Messfunktionen verwirklicht werden können, wie etwa die Messung und Darstellung des Stroms, sowie, in Verbindung mit einem Spannungsabgriff, die Messung der Wirk-, Blind- und Scheinleistung.

Da die Schutzfunktion des Leistungsschalters sowohl im mehrphasigen, als auch im einphasigen Betrieb des eigenversorgten Leistungsschalters aktiv sein muss, kommen zur Energieversorgung der elektronischen Auslöseeinheit nur Stromwandler mit einem Kern aus einem ferromagnetischen Werkstoff, z.B. einem Eisenkern, in Frage. Zur sättigungs- und damit verzerrungsfreien Messung des Primärstromes durch die Hauptstrombahnen des Leistungsschalters werden vorzugsweise Rogowskispulen verwendet. Eine Rogowskispule ist eine zur Messung von Wechselstrom dienende Spule ohne ferromagnetischen Kern. In einer bevorzugten Ausführungsform der Erfindung weisen beide Spulen einen ringförmigen Kern auf. Damit kann der im Schaltgerät vorhandene Einbauraum bzw. der durch das Gehäuse entsprechend vorgegebene Aufnahmeraum bestmöglich genutzt werden. Zugleich ermöglicht die Ringform der Kerne eine besonders einfache und sichere Platzierung des Stromwandlers und der Rogowskispule in dem Gehäuse.

Zu diesem Zweck weist das Gehäuse in einer bevorzugten Ausführungsform der Erfindung für jede Phase ein Montageelement auf. Jedes Montageelement verfügt über einen durchgehenden Innenraum und dient als Träger für den Stromwandler und die Rogowskispule. Im Montageendzustand durchläuft der jeweilige Leiter das Montageelement und damit auch die vorzugsweise ringförmigen Kerne des Stromwandlers und der Rogowskispule. Wird sowohl für die Kerne des Stromwandlers und der Rogowskispule, als auch das Montageelement ein kreisrunder Querschnitt gewählt, ist beispielsweise das Montageelement als innen hohl ausgeführter Dom ausgebildet, so müssen zur Montage die Stromwandler lediglich auf das Montageelement aufgeschoben und dort gegebenenfalls fixiert werden. Ein runder Querschnitt des Montageelements ist an die vor allem bei Niederspannungsleistungsschaltern für geringe Nennströme zumeist runden Leiterquerschnitte der Stromschienen angepasst. Die Montageelemente sind jedoch vorteilhafterweise derart ausgeführt, dass auch Leiter mit rechteckigem Querschnitt durch das Gehäuse hindurchgeführt werden können.

Vorteilhafterweise ist zwischen dem Stromwandler und der Rogowskispule ein Abstandselement angeordnet. Die vorzugsweise aus einem thermisch und/oder elektrisch nicht leitenden Kunststoffmaterial gefertigten Abstandselemente, beispielsweise in Scheibenform, verhindern eine Berührung von Stromwandler und Rogowskispule. Da sich die Durchmesser der Drahtwicklungen von Rogowskispule und Stromwandler deutlich voneinander unterscheiden, dient das Abstandselement zugleich auch als Schutzelement, da es eine gegenseitige mechanische bzw. elektromagnetische Wechselwirkung der beiden Wicklungen verhindert.

In einer weiteren Ausführungsform der Erfindung ist, gegebenenfalls zusätzlich zu dem zwischen dem Stromwandler und der Rogowskispule angeordneten Abstandselement, ein Abstandselement an der Außenseite des Stromwandlers und/oder der Rogowskispule angeordnet. Dieses Abstandselement dient ebenfalls dem Schutz der Wicklungen.

Das zwischen Stromwandler und Rogowskispule und/oder das an einer der Außenseiten des Stromwandlers und/oder der Rogowskispule vorgesehene Abstandselement erfüllt in einer weiteren vorteilhaften Ausführungsform der Erfindung eine Mehrfachfunktion. So kann wenigstens eines der Abstandselemente zugleich zum Halten des Stromwandlers und der Rogowskispule in ihrer Einbauposition dienen, insbesondere von dem Zeitpunkt an, zu dem der Stromwandler und/oder die Rogowskispule auf das Montageelement aufgesteckt werden, bis zum Ausfüllen des Gehäuses mit einem Füllmaterial, wie dies im Detail weiter unten beschrieben ist. Zu diesem Zweck ist dieses Abstandselement mit Verbindungselementen, vorzugsweise in Gestalt von Klemm-, Rast- oder Schnappelementen oder dergleichen, ausgestattet, welche mit dem Montageelement bzw. mit an dem Montageelement vorgesehenen entsprechenden Verbindungselementen zusammenwirken.

In einer weiteren, vorteilhaften Ausführungsform der Erfindung weist ein der Rogowskispule und/oder dem Stromwandler zugeordnetes Abstandselement eine Halterung auf, an der die Löt- oder Krimpverbindung zwischen dem Lackdraht der Rogowskispule und/oder des Stromwandlers und einer im Querschnitt deutlich größeren Litze zum Anschluss an das Elektronikmodul fixiert werden kann.

In einer ganz besonders vorteilhaften Ausführungsform der Erfindung werden die nach dem Einbau der Stromwandler und der Rogowskispulen verbleibenden Leer- bzw. Hohlräume des Gehäuses zumindest teilweise mit einem idealerweise elektrisch nichtleitenden Füllmaterial ausgefüllt. Vorzugsweise verschließt das Füllmaterial zudem das Gehäuse, so dass ein zusätzliches Konstruktionselement, wie ein Deckel oder dergleichen zum Verschließen des Gehäuses nicht erforderlich ist. Vorzugsweise umschließt das Füllmaterial die in dem Gehäuse angeordneten Bauelemente vollständig nach Art einer Einkapselung. Bei dem Füllmaterial handelt es sich vorzugsweise um eine Vergussmasse, mit der die Kombinationswandleranordnung nach dem Einbau der Stromwandler und Rogowskispulen vergossen wird.

Im Zusammenhang mit der Verwendung eines elektrisch isolierenden Kunststoffmaterials für das Gehäuse der Kombinationswandleranordnung, wobei die Wandstärke des Kunststoffgehäuses vorzugsweise mindestens etwa 1 mm beträgt, sorgt das Füllmaterial für eine optimale Isolation zwischen den Hauptstrombahnen des Leistungsschalters und den Stromwandlern sowie Rogowskispulen bzw. zwischen den Hauptstrombahnen und der mit den Stromwandlern und Rogowskispulen elektrisch verbundenen elektronischen Auslöseeinheit. Dies ist besonders bei solchen Leistungsschaltern von Bedeutung, bei denen die elektronische Auslöseeinheit über einen Anschluss zur Kommunikation mit anderen Leistungsschaltern oder einer übergeordneten Kontrolleinheit verfügt. Über diese Kommunikationsverbindung können von der elektronischen Auslöseeinheit beispielsweise einzustellende Schutzparameter empfangen und Messwerten von Strom, Spannung und Leistung gesendet werden. In diesen Fällen muss eine sichere Trennung zwischen der Hauptstrombahn und den Schaltkreisen in der elektronischen Auslöseeinheit gewährleistet sein.

Besonders vorteilhaft ist es, dass durch die Verwendung des Füllmaterials die Notwendigkeit entfällt, Trennwände zwischen den einzelnen Phasen im Gehäuse vorzusehen. Somit verringert sich nicht nur der konstruktive Aufwand und damit die Herstellungskosten. Auch können die Außendurchmesser der Stromwandler vergleichsweise groß gewählt werden, mit positiven Auswirkungen auf den Aufbau und damit die elektrischen Übertragungseigenschaften der Stromwandler und Rogowskispulen.

Ist das Füllmaterial thermisch leitend, gewährleistet es eine Wärmeabfuhr der in den Sekundärwicklungen erzeugten Wärme an die Umgebung. Unzulässig hohe Temperaturen in der Sekundärwicklung sowie in der Kombinationswandleranordnung insgesamt können dadurch vermieden werden. Zu einer solchen Erwärmung kann es in Folge der in der Sekundärwicklung des Stromwandlers mit Eisenkern bei Stromfluss erzeugten Verlustleistung kommen.

Gegenüber den zum Teil konstruktiv sehr komplexen und damit teueren Lösungen, wie sie aus dem Stand der Technik bekannt sind, wird mit der Erfindung eine vergleichsweise einfache und kostengünstige Kombinationswandleranordnung bereitgestellt. Sowohl der Zusammenbau, insbesondere der Einbau der Stromwandler und Rogowskispulen in das Gehäuse, als auch das Einbringen des Füllmaterials, insbesondere durch einen Verguss des Kombinationswandlermoduls, sind vergleichsweise kostengünstig durchführbar. Im Ergebnis entsteht ein sehr kompaktes Kombinationswandlermodul, das mit einem sehr geringen Risiko einer Beschädigung transportiert, verbaut und betrieben werden kann. Auch ein falscher Anschluss der Kombiwandler mit falscher Zuordnung der Phase an der Elektronik während der Fertigung ist durch die Modulbauweise ausgeschlossen.

Zusammengefasst ist die erfindungsgemäße Anordnung sehr robust, einfach herzustellen, kostengünstig und verfügt über sehr gute elektrische Isolationseigenschaften. Gegenüber drei einzelnen Kombinationswandlern, wie sie beispielsweise zur Bestückung eines dreiphasigen Leistungsschalters im Stand der Technik verwendet werden, ergibt sich mit der vorgestellten Kombinationswandleranordnung ein Kostenvorteil.

Die Erfindung ist besonders vorteilhaft bei Niederspannungsleistungsschaltern einsetzbar. Dabei kann es sich sowohl um Kompaktleistungsschalter (MCCB, Moulded Case Circuit Breakers), als auch um offene Leistungsschalter (ACB, Air Circuit Breaker) handeln.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden. Dabei zeigen:
- FIG 1: eine vereinfachte Blockdarstellung eines Niederspannungsleistungsschalters,
- FIG 2: eine Kombinationswandleranordnung in Explosionsdarstellung,
- FIG 3: eine perspektivische Darstellung der Kombinationswandleranordnung mit Stromschienen,
- FIG 4: eine perspektivische Darstellung des Abstandhalters mit Löthilfe.

Sämtliche Figuren zeigen die Erfindung lediglich schematisch und mit ihren wesentlichen Bestandteilen. Gleiche Bezugszeichen entsprechen dabei Elementen gleicher oder vergleichbarer Funktion.

Beispielhaft ist nachfolgend eine Kombinationswandleranordnung bzw. ein Niederspannungsleistungsschalter mit einer solchen Kombinationswandleranordnung beschrieben.

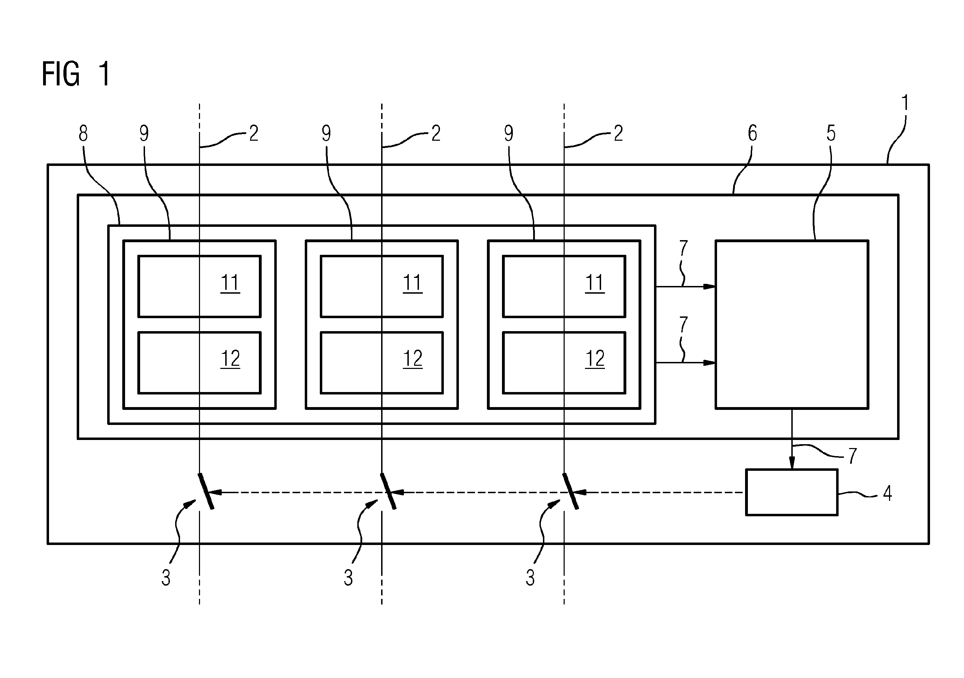

Der in FIG 1 abgebildete Leistungsschalter 1 ist zum Schalten von drei elektrischen Leitern 2 mit Hilfe von Schaltkontakten 3 ausgebildet. Die Schaltkontakte 3 sind über einen Auslösemechanismus 4 betätigbar. Die elektronische Auslöseeinheit 6 des Leistungsschalters 1 umfasst ein Elektronikmodul 5 sowie ein Kombinationswandlermodul 8. Der Auslösemechanismus 4 wird von dem Elektronikmodul 5 in Abhängigkeit von einem Stromwert angesteuert. Hierzu ist das Elektronikmodul 5 über Verbindungsleitungen 7 einerseits mit dem Auslösemechanismus 4 und andererseits mit einem erfindungsgemäßen Kombinationswandlermodul 8 verbunden. Das Kombinationswandlermodul 8 dient sowohl zur Erfassung des Stroms in den drei Leitern 2 sowie zur Versorgung des Elektronikmoduls 5 mit Energie. Zu diesem Zweck umfasst es drei Kombinationswandler 9, die in einem gemeinsamen Gehäuse 10 aus Kunststoffmaterial angeordnet sind. Jeder Kombinationswandler 9 weist eine Rogowskispule 11 zur Strommessung und einen Stromwandler 12 mit Eisenkern zur Energieversorgung des Elektronikmoduls 5 auf. Die Rogowskispule 11 liefert als Ausgangssignal eine elektrische Spannung, die proportional ist zur zeitlichen Änderung des Stroms in dem Leiter 2, den die Rogowskispule 11 umfasst. Aus diesem Spannungssignal wird im Elektronikmodul 5 der elektronischen Auslöseeinheit 6 mittels analoger Signalverarbeitung und nachgeschaltetem Mikrocontroller mit Analog-Digital-Wandler der zeitliche Verlauf sowie der Effektivwert des Stroms im Leiter 2 ermittelt. Überschreitet der zeitliche Verlauf des Stroms bzw. der Effektivwert für eine bestimmte Zeitdauer einen festgelegten Schwellwert, so wird der Auslösemechanismus 4 vom Elektronikmodul 5 angesteuert und die Schaltkontakte 3 dadurch geöffnet.

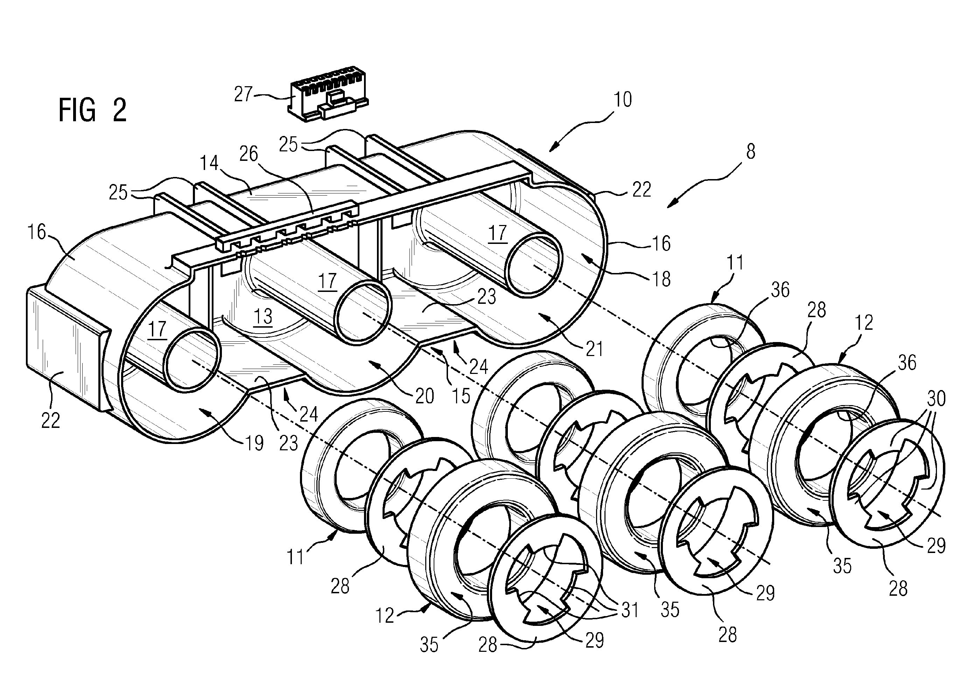

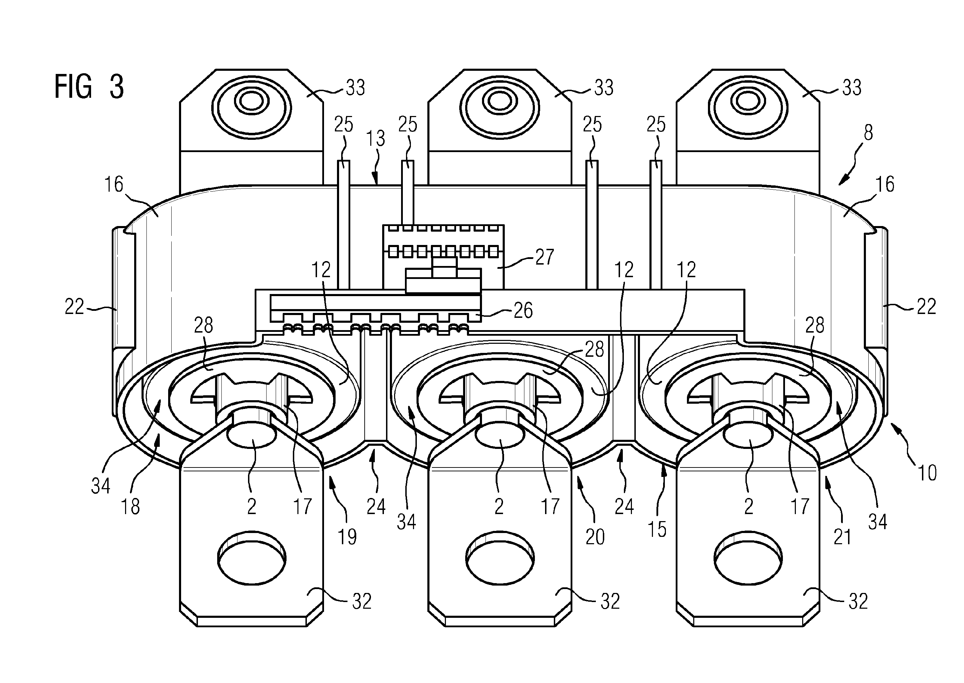

Wie in FIG 2 und 3 dargestellt, besteht das Gehäuse 10 des Kombinationswandlermoduls 8 im wesentlichen aus einer Rückwand 13, einer sich an die Rückwand 13 anschließenden Gehäusedecke 14, einem sich an die Rückwand 13 anschließenden, der Gehäusedecke 14 gegenüberliegenden Gehäuseboden 15 und zwei sich an die Rückwand 13 anschließende, den Gehäuseboden 15 mit der Gehäusedecke 14 verbindenden Seitenwänden 16. Ausgehend von der Rückwand 13 erstrecken sich drei nach Art Domen ausgeführte Montageelemente 17 in Richtung der offenen Gehäusevorderseite 18. Die innen mit einer durchgehenden Öffnung versehenen Montageelemente 17 verlaufen parallel zu den Leitern 2 im Leistungsschalter 1, welche später durch die Montageelemente 17 hindurchgeführt werden.

Das Gehäuse 10 umfasst, entsprechend der Anzahl der Phasen, drei miteinander verbundene Teilabschnitte 19, 20, 21, wobei jeder Gehäuseteilabschnitt 19, 20, 21 zumindest teilweise eine zylindrische Form aufweist. So sind die beiden äußeren Teilabschnitte 19, 21 des Gehäuses 10 bei der in FIG 2 dargestellten Ausführungsform zu mehr als 50 Prozent bzw. bei der in FIG 3 dargestellten Ausführungsform zu nahezu 75 Prozent zylinderförmig ausgeführt, weshalb die Seitenwände 16 des Gehäuses 10 plattenförmige Montageschienen 22 zur Montage des Gehäuses 10 in entsprechenden Aufnahmenuten (nicht abgebildet) des Schaltgerätes 1 aufweisen. Die Form des Gehäusebodens 15 wird durch die Zylinderform der Teilabschnitte 19, 20, 21 wesentlich bestimmt. Dabei gehen die Teilabschnitte 19, 20, 21 unmittelbar, wie bei der in FIG 3 dargestellten Ausführungsform, oder über ein ebenes Verbindungsstück 23, wie bei der in FIG 2 dargestellten Ausführungsform, ineinander über. Die dadurch gebildeten Aussparungen 24 bzw. zusätzlich am Gehäuseboden 15 angebrachten Rippen (nicht dargestellt) dienen einer optimierten Ausleitung des im Kurzschlussfall entstehenden Abgasstromes aus dem Leistungsschalter 1. Die Gehäusedecke 14 ist eben ausgeführt. Aus der Rückwand 13 des Gehäuses 10 ragen aus Gehäusematerial gefertigte Rippen 25 heraus, die jeweils paarweise zwischen den im Montageendzustand aus dem Gehäuse 10 austretenden als Stromschienen ausgebildeten Leitern 2 platziert sind und zur Einhaltung der geforderten Luft- und Kriechstrecken zwischen den Hauptstrombahnen dienen, siehe FIG 3. Eine nahe der Gehäusevorderseite 18 auf der Gehäusedecke 14 angeordnete, nach Art einer Brücke ausgeführte Halterung 26 dient zur Befestigung der später aus dem Füllmaterials herausragenden Anschlussleitungen (nicht dargestellt) der Rogowskispule 11 bzw. des Stromwandlers 12, so dass diese bis zum Aushärten des Füllmaterials in der vorgesehenen Position verbleiben. Die mit den Enden der Sekundärwicklungen (nicht dargestellt) der Rogowskispule 11 und des Stromwandlers 12 verbundenen Anschlussleitungen (nicht dargestellt) sind mit einem Anschlussstecker 27 verbunden. Dieser Anschlussstecker 27 ermöglicht eine elektrische Verbindung des Kombinationswandlermoduls 8 mit dem Elektronikmodul 5 der elektronischen Auslöseeinheit 6 des Leistungsschalters 1 über eine Verbindungsleitung 7.

Das Kombinationswandlermodul 8 weist pro Phase eine Rogowskispule 11 sowie einen Stromwandler 12 auf. Jede Rogowskispule 11 weist einen ringförmigen, bewickelten Kunststoff- oder Keramikkern und jeder Stromwandler 12 einen ringförmigen, bewickelten Ringbandeisenkern auf, so dass jeweils eine durchgehende Öffnung 36 ausgebildet wird. Bei dem Zusammenbau des Kombinationswandlermoduls 8 wird jeweils eine Rogowskispule 11 und ein Stromwandler 12 auf ein Montageelement 17 aufgeschoben. Dabei wird eine als Abstandshalter dienende Kunststoffscheibe 28 zwischen der Rogowskispule 11 und dem Stromwandler 12 angeordnet, die dem Berührungsschutz dient. Die Kunststoffscheibe 28 weist zur Montage auf dem Montageelement 17 eine zentrale Öffnung 29 auf, deren Durchmesser im wesentlichen dem Außendurchmesser des Montageelements 17 entspricht. Eine weitere, im vorliegenden Fall baugleiche Kunststoffscheibe 28, wird an der der Gehäusevorderseite 18 zugewandten, der Rogowskispule gegenüberliegenden Außenseite 35 des Stromwandlers 12 platziert. Damit wird der Stromwandler 12 beidseitig gegen Berührung geschützt. Die Kunststoffscheiben 28 weisen drei Befestigungselemente in Form von Klemmbacken 30 auf, die sich, gleichmäßig voneinander beabstandet, ausgehend von dem Rand einer ersten in der Kunststoffscheibe 28 eingebrachten Öffnung mit größerem Durchmesser in Richtung der Scheibenmitte erstrecken und mit ihren Freienden 31 den Durchmesser der sich ergebenden, nutzbaren Öffnung 29 mit kleinerem Durchmesser definieren, so dass die Kunststoffscheiben 28 in auf dem Montageelement 17 montierten Zustand zugleich die Einbauposition der Rogowskispule 11 und des Stromwandlers 12 gegen Verrutschen festlegen. Für eine gleichbleibende Genauigkeit der Strommessung hat es sich als besonders vorteilhaft erwiesen, die Rogowskispulen 11 als erstes in das Gehäuse 10 einzulegen, so dass diese an der Gehäuserückwand 13 anliegen. Dadurch wird ein besonders sicherer Halt in der Einbauposition auch während des anschließenden Befüllens des Gehäuses 10 mit Vergussmasse erreicht.

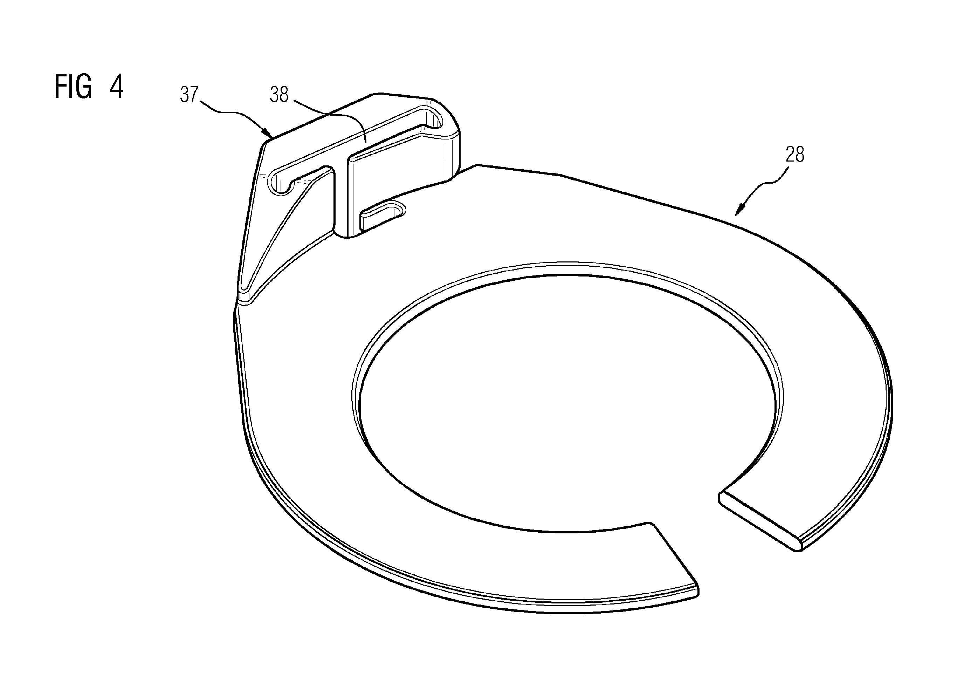

In FIG 4 ist eine als Abstandselement dienende alternative Kunststoffscheibe 28 dargestellt, welche in einer weiteren Ausführungsform der Erfindung an die Stelle des zwischen der Rogowskispule 11 und dem Stromwandler 12 angeordneten Abstandselements tritt. Die alternative Kunststoffscheibe 28 weist keine Befestigungselemente auf, so dass in diesem Fall die Einbauposition der Rogowskispule 11 und des Stromwandlers 12 ausschließlich durch die zweite, vordere Kunststoffscheibe 28 erfolgt. Jedoch verfügt die alternative Kunststoffscheibe 28 über eine erste, nahe des Umfangs der Scheibe angeordnete, senkrecht von der Scheibenoberfläche wegstehende, im montierten Zustand am Umfang der Rogowskispule 11 anliegende bzw. die Rogowskispule 11 umgreifende Halterung 37 mit Aufnahmeöffnungen bzw. -führungen 38 für das Anschlussende einer aus der Rogowskispule 11 herausführenden dünnen elektrischen Anschlussleitung einerseits und das Anschlussende einer Verbindungsleitung zu dem Elektronikmodul 5 andererseits. Zudem verfügt die alternative Kunststoffscheibe 28 über eine zweite Halterung 37 (in FIG 4 nicht sichtbar), die identisch mit der ersten Halterung 37 und spiegelsymmetrisch zu dieser angeordnet ist derart, dass sie in die entgegengesetzte Richtung weist und im eingebauten Zustand am Umfang des Stromwandlers 12 anliegt bzw. den Stromwandler 12 umgreift. Dadurch, dass die Anschlussenden in den Halterungen 37 sicher gehalten werden, wird ein maschinelles Verlöten der Anschlussenden ermöglicht. Die Halterungen 37 können auch zur Ausführung einer Krimpverbindung zwischen den Anschlussenden ausgebildet sein. Die Kunststoffscheibe 28 muss jedoch nicht zwei Halterungen 37 aufweisen. Auch eine Ausführung mit nur einer Halterung 37, beispielsweise einer nur der Rogowskispule zugeordneten Halterung, ist ebenfalls möglich.

Nachdem die Rogowskispulen 11, Stromwandler 12 und Kunststoffscheiben 28 in das Gehäuse 10 eingelegt worden sind, wird das Gehäuse 10 mit Vergussmasse befüllt. In FIG 3 ist das Kombinationswandlermodul 8 im betriebsfertigen Zustand dargestellt, wobei jedoch aus Gründen der Klarheit die Vergussmasse nicht dargestellt ist. Die drei durch das Gehäuse 10 hindurchgeführten, an beiden Enden mit Anschlusskontakten 32, 33 zum Anschließen an die Hauptstrombahn des Leistungsschalters 1 versehenen Leiter 2 weisen auf der Länge des Gehäusedurchtritts einen kreisrunden Querschnitt auf. Vorzugsweise ist der Innendurchmesser der Montageelemente 17 an den Außendurchmesser der Leiter 2 angepasst.

Im betriebsfertigen Zustand füllt die Vergussmasse die Zwischenräume 34 zwischen den Rogowskispulen 11 und den Stromwandlern 12 bzw. zwischen diesen und der Gehäusedecke 14, dem Gehäuseboden 15, der Rückwand 13 des Gehäuses und dem Gehäuseseitenwänden 16 aus und bedeckt die stirnseitigen Kunststoffscheiben 28 vollständig, so dass sie das Gehäuse 10 nach vorn vollständig verschließt. Alternativ zu der Verwendung einer Vergussmasse kann ein anderes Füllmaterial, beispielsweise ein in das Gehäuse 10 einzulegendes Isoliermaterial, verwendet werden. In einer weiteren Ausgestaltung kann ein Kunststoffdeckel auf das Gehäuse 10 aufgebracht und mittels einer Steckverbindung oder Ultraschallschweißen oder dergleichen fixiert werden.

Es ist grundsätzlich möglich, zur Messung der Primärströme keine Rogowskispulen 11, sondern andere Sensoren zu verwenden. Dabei kann es sich beispielsweise um einen Stromwandler mit Eisenkern oder um einen Hall-Sensor handeln. Sofern diese anderen Sensoren ebenfalls über einen vorzugsweise ringförmigen Kern verfügen, lassen sich die konstruktionsbedingten Vorteile bei dem Einbau in das Gehäuse 10 auch auf diese weiteren Sensoren übertragen.

Bei dem oben beschriebenen Ausführungsbeispiel wird eine Kombinationswandleranordnung in einer dreipoligen Ausführung beschrieben. Analog dazu sind auch zwei- und vierpolige Ausführungen usw. möglich. Selbstverständlich ist es ebenfalls möglich, die gezeigte konstruktive Ausgestaltung in einer einpoligen Ausführung zu realisieren.

Obwohl die Erfindung im Detail durch das bevorzugte Ausführungsbeispiel näher illustriert und beschrieben wurde, so ist die Erfindung nicht auf die offenbarten Beispiele eingeschränkt und andere Variationen können vom Fachmann hieraus abgeleitet werden, ohne den Schutzumfang der Erfindung zu verlassen.

## Patentansprüche

1. Kombinationswandleranordnung (8),
**dadurch gekennzeichnet,**
**dass** mehrere Kombinationswandler (9), jeder Kombinationswandler (9) eine Rogowskispule (11) und einen Stromwandler (12) aufweisend, in einem gemeinsamen Gehäuse (10) angeordnet sind.

2. Kombinationswandleranordnung (8) nach Anspruch 1, **dadurch gekennzeichnet,**
**dass** die Rogowskispule (11) jedes Kombinationswandlers (9) einen ringförmigen bewickelten Kunststoff- oder Keramikkern und der Stromwandler (12) jedes Kombinationswandlers (9) einen ringförmigen bewickelten Kern aus einem ferromagnetischen Werkstoff aufweist.

3. Kombinationswandleranordnung (8) nach Anspruch 1 oder 2, **dadurch gekennzeichnet,**
**dass** das Gehäuse (10) für jede Phase ein Montageelement (17) aufweist, das von einem der jeweiligen Phase zugeordneten elektrischen Leiter (2) durchlaufen wird, und das als Träger für die Rogowskispule (11) und den Stromwandler (12) des dieser Phase zugeordneten Kombinationswandlers (9) dient.

4. Kombinationswandleranordnung (8) nach Anspruch 3, **dadurch gekennzeichnet,**
**dass** die Rogowskispule (11) derart auf dem Montageelement (17) angeordnet ist, dass sie an der Rückwand (13) des Gehäuses (10) anliegt.

5. Kombinationswandleranordnung (8) nach einem der Ansprüche 1 bis 4,
**dadurch gekennzeichnet,**
**dass** ein Abstandselement (28) zwischen der Rogowskispule (11) und dem Stromwandler (12) jedes Kombinationswandlers (9) angeordnet ist und/oder dass ein Abstandselement (28) an der Außenseite der Rogowskispule (11) und/oder an der Außenseite (35) des Stromwandlers (12) jedes Kombinationswandlers (9) angeordnet ist.

6. Kombinationswandleranordnung (8) nach Anspruch 5, **dadurch gekennzeichnet,**
**dass** das zwischen der Rogowskispule (11) und dem Stromwandler (12) jedes Kombinationswandlers (9) angeordnete Abstandselement (28) und/oder das an der Außenseite der Rogowskispule (11) und/oder an der Außenseite (35) des Stromwandlers (12) jedes Kombinationswandlers (9) angeordnete Abstandselement (28) mit Befestigungselementen (30) zum Halten der Rogowskispule (11) und des Stromwandlers (12) in ihrer Einbauposition in dem Gehäuse (10) und/oder mit einer Halterung für Anschlussenden elektrischer Anschlussleitungen versehen ist.

7. Kombinationswandleranordnung (8) nach einem der Ansprüche 1 bis 6,
**dadurch gekennzeichnet,**
**dass** die Leerräume (34) des Gehäuses (10) zumindest teilweise mit einem elektrisch nicht leitenden Füllmaterial ausgefüllt sind.

8. Schaltgerät (1), insbesondere Niederspannungsleistungsschalter, mit einer elektrischen Auslöseeinheit (6), **dadurch gekennzeichnet,**
**dass** die elektrischen Auslöseeinheit (6) eine Kombinationswandleranordnung (8) nach einem der Ansprüche 1 bis 7 aufweist.

9. Schaltgerät (1) nach Anspruch 8,
**dadurch gekennzeichnet,**
**dass** jeder Kombinationswandler (9) der Kombinationswandleranordnung (8) einer Phase des Schaltgerätes (1) zugeordnet ist.

10. Schaltgerät (1) nach Anspruch 8 oder 9,
**dadurch gekennzeichnet,**
**dass** die Rogowskispule (11) jedes Kombinationswandlers (9) zur Messung des Primärstroms dient und der Stromwandler (12) jedes Kombinationswandlers (9) zur Energieversorgung des Elektronikmoduls (5) der elektronischen Auslöseeinheit (6) ausgebildet ist.
